# EUROPEAN PATENT APPLICATION

(11) **EP 4 836 612 A1**
(43) Date of publication of application: **04.11.2026**
(21) Application number: 24909441.8
(22) Date of filing: 28.03.2024
(51) Int. Cl.: H05K 7/20

(54) **POWER CONVERSION APPARATUS**

(30) Priority: 30.12.2023 CN 202323669798 U
(71) Applicant: Sungrow Power Supply Co., Ltd., Hefei, Anhui 230088 (CN)
(72) Inventor: WANG, Wei, Hefei, Anhui 230088 (CN); YU, Renbin, Hefei, Anhui 230088 (CN); YANG, Ye, Hefei, Anhui 230088 (CN); ZHOU, Jie, Hefei, Anhui 230088 (CN); LIU, Long, Hefei, Anhui 230088 (CN); WANG, Peng, Hefei, Anhui 230088 (CN)
(74) Representative: Zacco Norway AS
(86) International application number: PCT/CN2024/084316
(87) International publication number: WO 2025/138472

(57) **Abstract**

Disclosed in the present application is a power conversion apparatus, comprising a first cavity, a second cavity and a heat dissipator, wherein a power device is provided in the first cavity; the heat dissipator comprises an evaporator and a condenser, which forms a circulating flow path with the evaporator, the evaporator being configured to absorb heat of the power device; the condenser is located in the second cavity, and the second cavity can allow air to flow through the condenser to cool the condenser; and the evaporator is located outside the second cavity. In the power conversion apparatus, the heat dissipator is used to perform heat dissipation on the power device, such that the heat dissipation capacity is improved; the evaporator is externally arranged relative to the condenser, such that the second cavity has a relatively small size, thereby facilitating the mounting, disassembly and maintenance of the second cavity; and the evaporator and the condenser are not in the same cavity, such that hot air in the second cavity is prevented from affecting the evaporator, and the temperature of the evaporator is relatively lower, thereby making a heat dissipation effect of the evaporator better, and thus improving a heat dissipation effect of the power conversion apparatus.

## Description

The present application claims priority to Chinese Patent Application No. 202323669798.2, titled "POWER CONVERSION APPARATUS", filed on December 30, 2023 with the China National Intellectual Property Administration, which is incorporated herein by reference in its entirety.

### FIELD

The present application relates to the technical field of heat dissipation of power electronic equipment, and in particular, to a power conversion apparatus.

### BACKGROUND

With the continuous increase in the power density of power conversion apparatus, such as inverters and power conversion systems (PCS), heat generation of such apparatus -particularly that of power devices within an enclosure-is growing significantly. Consequently, there is an increasingly high requirement for the heat dissipation capability of power conversion equipment.

Currently, power conversion apparatus primarily employs forced air cooling. However, the heat dissipation capacity of forced air cooling is difficult to be further improved, making it challenging to meet the heat dissipation requirements of the power conversion apparatus with ever-increasing power density.

In summary, how to design the heat dissipation of the power conversion apparatus to enhance the heat dissipation capacity and meet the heat dissipation requirements of the power conversion apparatus is an urgent issue that needs to be addressed by those skilled in the art.

### SUMMARY

In view of this, an object of the present application is to provide a power conversion apparatus to improve the heat dissipation capacity and meet the heat dissipation requirements of the power conversion apparatus.

In order to achieve the above object, the following technical solutions are provided according to the present application.

A power conversion apparatus includes a first chamber, a second chamber, and a heat sink,
where a power device is disposed in the first chamber; the heat sink includes an evaporator and a condenser connected to the evaporator to form a circulation flow path, and the evaporator is configured to absorb heat from the power device; and
the condenser is disposed in the second chamber, which is configured to allow air to flow through the condenser for cooling, and the evaporator is disposed outside the second chamber.

Optionally, the evaporator is disposed outside the first chamber.

Optionally, a magnetic device is further disposed in the second chamber.

Optionally, the magnetic device is located on an outer top of the first chamber.

Optionally, the magnetic device is disposed on a side of the first chamber.

Optionally, the magnetic device and the evaporator are located on the same side of the first chamber.

Optionally, the magnetic device is distributed on one side of the evaporator. Alternatively, there are at least two magnetic devices, which are respectively distributed on both sides of the evaporator.

Optionally, the magnetic device disposed in the second chamber is defined as a first magnetic device.

The power conversion apparatus further includes a third chamber, within which a second magnetic device is disposed.

Optionally, the evaporator is disposed in the third chamber.

Additionally/alternatively, the third chamber is configured to allow air to flow over the second magnetic device for cooling the second magnetic device.

Optionally, a magnetic device is further disposed outside both the second chamber and the first chamber.

Optionally, the evaporator and the magnetic device are arranged independently.

Optionally, the evaporator includes a first evaporation module and a second evaporation module. The first evaporation module is configured to absorb heat from the power device, and the second evaporation module is configured to absorb heat from the magnetic device.

Optionally, the first evaporation module and the second evaporation module are different.

The first evaporation module and the second evaporation module share the same condenser. Alternatively, the first evaporation module and the second evaporation module are respectively connected to different condensers.

Optionally, the first evaporation module and the second evaporation module are the same evaporation module

Optionally, the power conversion apparatus further includes a fourth chamber, and the evaporator is disposed in the fourth chamber.

Optionally, the evaporator is disposed on the top or a side of the first chamber.

Optionally, the magnetic device is disposed in the fourth chamber.

Optionally, the fourth chamber is configured to allow air to flow over the magnetic device for cooling the magnetic device.

Optionally, the fourth chamber his provided with an air duct for air flow, and the air duct is configured for air to flow over the magnetic device but bypasses the evaporator.

Additionally/alternatively, one of a fourth chamber air inlet and a fourth chamber air outlet is provided lower than the magnetic device, whereas the other one is provided higher than the magnetic device. Additionally, the magnetic device is located lower than the evaporator, and the other one of the fourth chamber air inlet and the fourth chamber air outlet, being provided higher than the magnetic device, is lower than a top end of the evaporator.

Additionally/alternatively, a fan is disposed in the fourth chamber and located on a side of the magnetic device away from the evaporator.

Optionally, the power conversion apparatus further includes a fifth chamber, and the magnetic device is located in the fifth chamber. The fifth chamber is configured to allow air to flow over the magnetic device for cooling the magnetic device.

Optionally, the second chamber and the fifth chamber share a fan to enable air to flow through the condenser and over the magnetic device. The fan is located outside both the second chamber and the fifth chamber.

Optionally, the fifth chamber is arranged in parallel or in series with the second chamber.

Optionally, a second chamber air inlet faces the magnetic device to allow the airflow to dissipate heat from the magnetic device before entering the second chamber air inlet. Alternatively, a second chamber air outlet faces the magnetic device to allow the airflow discharged from the second chamber air outlet to dissipate heat from the magnetic device.

Optionally, the evaporator is disposed in the first chamber.

In the power conversion apparatus according to the present application, a heat sink is employed to dissipate heat form the power device. Compared with the air-cooling heat dissipation used in the related technologies, this design effectively improves the heat dissipation capacity, and satisfies the heat dissipation requirements of the power conversion apparatus with high power density, thereby addressing the issue of insufficient heat dissipation capacity of traditional air cooling as the power density increases. Furthermore, the evaporator is externally arranged relative to the condenser, so that the second chamber has a relatively small size, thereby facilitating the mounting, disassembly and maintenance of the second chamber. The evaporator and the condenser are not located in the same chamber, so that the hot air within the second chamber is prevented from affecting the evaporator, and the temperature of the evaporator is relatively low. Consequently, the heat dissipation effect of the evaporator is enhanced, thereby improving the heat dissipation effect of the power conversion apparatus.

### BRIEF DESCRIPTION OF THE DRAWINGS

In order to more clearly illustrate the technical solutions in the embodiments of the present application or in the related technologies, the accompanying drawings required for describing the embodiments or the related technologies will be briefly introduced below. It is apparent that the accompanying drawings described below only show some embodiments of the present application. Based on these accompanying drawings, other accompanying drawings may be obtained by those ordinary skilled in the art without any creative effort.
FIG. 1 is a schematic view showing a structure of a power conversion apparatus according to a first embodiment of the present application;
FIG. 2 is a front view showing another structure of the power conversion apparatus according to the first embodiment of the present application;
FIG. 3 is a front view showing yet another structure of the power conversion apparatus according to the first embodiment of the present application;
FIG. 4 is a front view showing still another structure of the power conversion apparatus according to the first embodiment of the present application;
FIG. 5 is a side view of the power conversion apparatus shown in FIG. 4;
FIG. 6 is a top view of the power conversion apparatus shown in FIG. 4;
FIG. 7 is a front view showing another structure of the power conversion apparatus according to the first embodiment of the present application;
FIG. 8 is a front view showing yet another structure of the power conversion apparatus according to the first embodiment of the present application;
FIG. 9 is a schematic structural view of a power conversion apparatus according to a second embodiment of the present application;
FIG. 10 is another schematic structural view of the power conversion apparatus according to the second embodiment of the present application;
FIG. 11 is a schematic structural view of a power conversion apparatus according to a third embodiment of the present application;
FIG. 12 is another schematic structural view of the power conversion apparatus according to the third embodiment of the present application;
FIG. 13 is yet another schematic structural view of the power conversion apparatus according to the third embodiment of the present application;
FIG. 14 is a schematic structural view of a power conversion apparatus according to a fourth embodiment of the present application;
FIG. 15 is a front view of a power conversion apparatus according to a fifth embodiment of the present application;
FIG. 16 is a side view of the power conversion apparatus shown in FIG. 15;
FIG. 17 is a side view of the power conversion apparatus shown in FIG. 15;
FIG. 18 is a schematic structural view of a power conversion apparatus according to a sixth embodiment of the present application; and
FIG. 19 is another schematic structural view of the power conversion apparatus according to the sixth embodiment of the present application.

Numeral references are listed as follows:
1. first chamber; 101. back plate; 2. second chamber; 201. second chamber air inlet; 202. second chamber air outlet; 203. top chamber; 204. side chamber; 3. condenser; 4. evaporator; 401. first evaporation module; 402. second evaporation module; 403. evaporation module; 5. first fan; 6. power device; 7. magnetic device; 8. fourth chamber; 801. fourth chamber air inlet; 802. fourth chamber air outlet; 9. second fan; 10. third fan; 11. fifth chamber.

### DETAILED DESCRIPTION OF THE EMBODIMENTS

Technical solutions in the embodiments of the present application are described clearly and completely below with reference to the accompanying drawings herein. It is apparent that the described embodiments are only some rather than all of the embodiments of the present application. Based on the embodiments of the present application, all other embodiments obtained by those skilled in the art without any creative work fall within the protection scope of the present application.

Technical solutions in the embodiments of the present application will be described clearly and completely below with reference to the accompany drawings herein. The terms in the following embodiments are used merely for the purpose of describing specific embodiments, and are not intended to limit the present application. As used in the specification and appended claims of the present application, the singular expressions such as "a", "one", "said", "the above", "the" and "this" are intended to include expressions such as "one or more", unless explicitly indicated otherwise in the context. It should also be understood that in the embodiments of the present application, the expression "one or more" refers to one, two or more. The expression "and/or" describes an association relationship between related objects and indicates there may be three types of relationships. For example, A and/or B may indicate three cases: A exists alone, A and B exist simultaneously, and B exists alone. In each case, the number of A may be one or more, and the number of B may be one or more. The character "/" generally indicates that an "or" relationship between the associated objects before and after the character "/".

In this specification, references to "one embodiment" or "some embodiments" and the like mean that a particular feature, structure, or characteristic described in conjunction with the embodiment is included in one or more embodiments of the present application. Thus, phrases such as "in one embodiment", "in some embodiments", "in other embodiments" and "in yet other embodiments" and the like appearing throughout this specification do not necessarily all refer to the same embodiment. Rather, they mean "one or more, but not all embodiments" unless otherwise specifically emphasized. The terms such as "comprising", "including", "having" and variations thereof mean "including, but not limited to" unless otherwise specifically emphasized.

The term "multiple or a plurality of" in the embodiments of the present application refers to two or more. It should be noted that in the description of the embodiments of the present application, words such as "first" and "second" are only used for the purpose of distinguishing descriptions, and should not be understood as indicating or implying relative importance or a specific order.

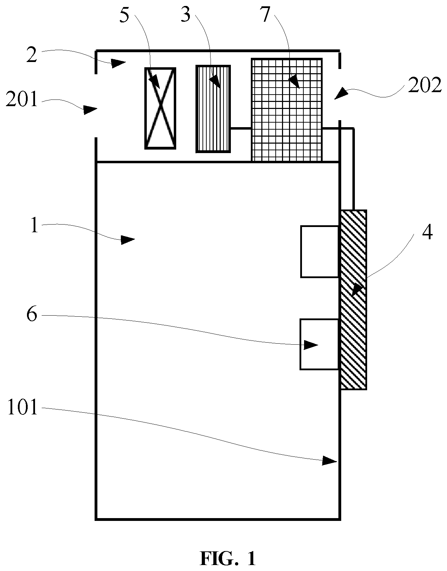

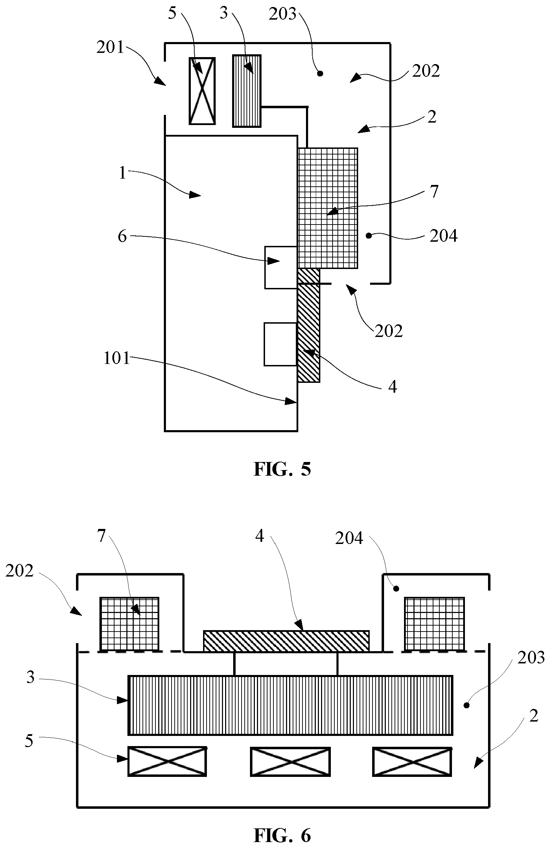

As shown in FIGS. 1 to 19, a power conversion apparatus provided according to an embodiment of the present application includes: a first chamber 1, a second chamber 2, and a heat sink (not shown in the figures).

A power device 6 is arranged in the first chamber 1. The power device 6 includes an insulate-gate bipolar transistor (IGBT) and the like, and the specific type and structure of the power device 6 are not limited in this embodiment.

In practical scenarios, other devices, such as resistors, capacitors, chips, etc., may also be arranged in the first chamber 1, which are not limited in this embodiment. It should be noted that the resistor is one type of magnetic device.

The first chamber 1 may be a closed chamber or a high-protection chamber with relatively high protective performance.

The heat sink includes an evaporator 4 and a condenser 3 that connected to the evaporator 4 to form a circulation flow path.

It should be noted that a circulation flow path is formed between the evaporator 4 and the condenser 3 through a gas phase pipeline and a liquid phase pipeline. The gas phase pipeline is configured to connect an outlet of the evaporator 4 to an inlet of the condenser 3, whereas the liquid phase pipeline is configured to connect an outlet of the condenser 3 to an inlet of the evaporator 4. A phase-change working medium can flow in the circulation flow path. To facilitate the circulation of the phase-change working medium, the condenser 3 and the evaporator 4 may be arranged at the same height, or the condenser 3 may be positioned higher than the evaporator 4.

The heat dissipation principle of the heat sink is as follows. The phase-change working medium inside the evaporator 4 absorbs heat and transforms from liquid phase to gas phase. The gas enters the condenser 3 through the gas phase pipeline, releases heat and condenses into liquid in the condenser 3. The liquid then flows back to the evaporator 4 through the liquid phase pipeline, completing the circulation.

The evaporator 4 is configured to absorb heat from the power device 6. Of course, the evaporator 4 may also absorb heat from other heat-generating devices in the first chamber 1, which is not limited in this embodiment.

The evaporator 4 is configured to be in a direct contact with the power device 6. Alternatively, the evaporator 4 is configured to be in an indirect contact with the power device 6 via a thermal conductive member.

The condenser 3 is disposed in the second chamber 2, and the second chamber 2 is configured to allow air to flow through the condenser 3 for cooling the condenser 3.

The condenser 3 may be a parallel-flow condenser or another type of condenser, which is not limited in this embodiment. Similarly, the type of the evaporator 4 is not limited in this embodiment.

The second chamber 2 has an air inlet and an air outlet, which may be called as a second chamber air inlet 201 and a second chamber air outlet 202, respectively. The second chamber 2 may be in communication with an external environment of the entire power conversion apparatus or with other chambers inside the power conversion apparatus except the first chamber 1, as long as the cooling of the condenser 3 is ensured.

To improve the cooling efficiency, the second chamber 2 may be configured as an open chamber, and the second chamber 2 is in communication with the external environment of the power conversion apparatus.

The relative positional relationship between the second chamber 2 and the first chamber 1 is determined based on actual conditions, which will not be limited in this embodiment.

To facilitate airflow to flow through the condenser 3, the power conversion apparatus further includes a first fan 5, which is configured to drive air to flow through the condenser 3. The type, number, and distribution of the first fan 5 are determined based on actual conditions, which will not be limited in this embodiment.

It should be noted that the first fan 5 may be removed if the heat dissipation requirements of the condenser 3 are met.

In the power conversion apparatus, a heat sink is employed to dissipate heat form the power device 6. Compared with the air-cooling heat dissipation used in some related technologies, this design effectively improves the heat dissipation capacity, and satisfies the heat dissipation requirements of the power conversion apparatus, especially those with high power density, thereby addressing the issue of insufficient heat dissipation capacity of traditional air cooling as the power density increases.

In the power conversion apparatus, the evaporator 4 is disposed outside the second chamber 2, so that the evaporator 4 is externally arranged relative to the condenser 3. As a result, the second chamber 2 has a relatively small size, thereby facilitating the mounting, disassembly and maintenance of the second chamber 2. Since the evaporator 4 and the condenser 3 are not disposed in the same chamber, and the hot airflow passing through the condenser 3 will bypass the evaporator 4, such that the hot air in the second chamber 2 is prevented from affecting the evaporator 4, and the temperature of the evaporator 4 is relatively low. Consequently, the heat dissipation effect of the evaporator 4 is enhanced, thereby improving the heat dissipation effect of the power conversion apparatus.

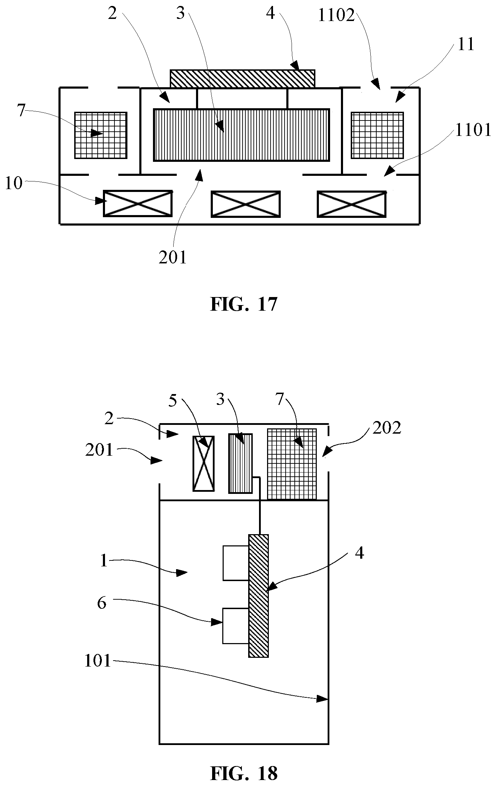

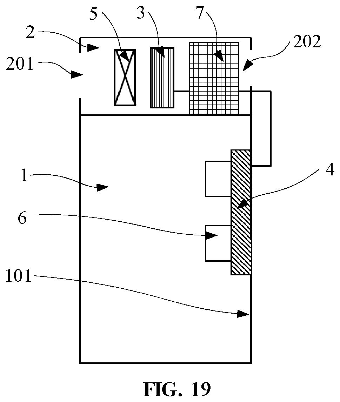

In the power conversion apparatus, the placement of the evaporator 4 is determined based on actual situations. In an aspect of the present application, as shown in FIGS. 1 to 17, the evaporator 4 may be disposed outside the first chamber 1. In another aspect of the present application, as shown in FIGS. 18 and 19, the evaporator 4 is disposed inside the first chamber 1.

In a case that the evaporator 4 is disposed outside the first chamber 1, the evaporator 4 may be arranged on an outer wall of the first chamber 1 to facilitate the mounting of the evaporator 4, thereby reducing the footprint of the entire structure.

In a case that the evaporator 4 is disposed outside the first chamber 1, the evaporator 4 may be disposed on a side of the first chamber 1 to facilitate the mounting of the evaporator 4.

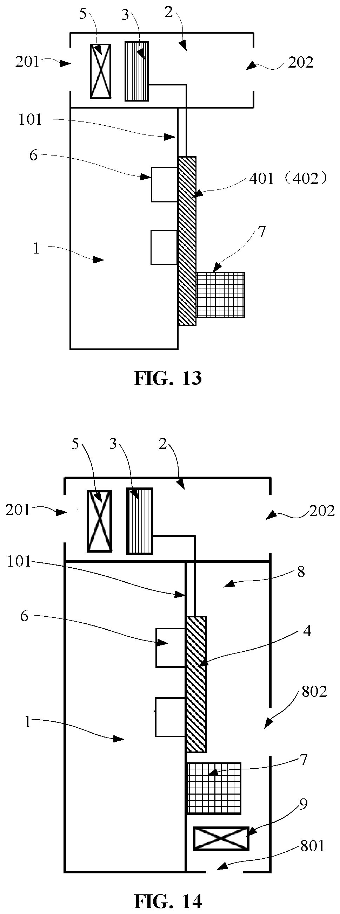

In a case that the evaporator 4 is disposed outside the first chamber 1, as shown in FIGS. 1 to 13 and 15 to 17, the evaporator 4 may be disposed outside both the first chamber 1 and the second chamber 2. As shown in FIG. 14, the power conversion apparatus may further include a fourth chamber 8, and the evaporator 4 is disposed in the fourth chamber 8.

In the power conversion apparatus, a magnetic device 7 may be arranged outside the first chamber 1. It should be noted that when a magnetic device such as a resistor is arranged inside the first chamber 1, the type of the magnetic device 7 arranged outside the first chamber 1 is different from the magnetic device inside the first chamber 1.

The magnetic device 7 may include a reactor or other devices, and the specific type of the magnetic device 7 is not limited in this embodiment.

In some embodiments, as shown in FIGS. 1 to 8, 18 and 19, a magnetic device 7 is further arranged in the second chamber 2.

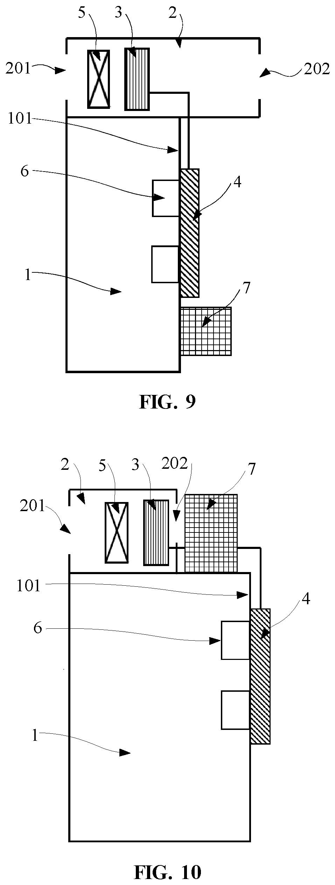

In some other embodiments, as shown in FIGS. 9 to 17, a magnetic device 7 is further arranged outside both the second chamber 2 and the first chamber 1. In this way, the magnetic device 7 is externally arranged relative to the condenser 3, so that the second chamber 2 has a relatively small size, thereby facilitating the mounting, disassembly and maintenance of the second chamber 2. The magnetic device 7 and the condenser 3 are not in the same chamber, so that the magnetic device 7 may be cooled separately, thereby enhancing the heat dissipation effect of the magnetic device 7. Additionally, this prevents mutual interference between the heat dissipation of the magnetic device 7 and the heat dissipation of the condenser 3, so that the condenser 3 and the magnetic device 7 may achieve better heat dissipation effect. Furthermore, the magnetic device 7 may be ignored during the design and mounting of the condenser 3, and similarly, the condenser 3 may be ignored during the design and mounting of the magnetic device 7, thereby enhancing the flexibility in the structural layout of the power conversion apparatus.

In the above embodiment, the air flowing through the condenser 3 may be directed towards the magnetic device 7. Specifically, the magnetic device 7 faces the second chamber air outlet 202 to enable the airflow discharged from the second chamber air outlet 202 to dissipate heat from the magnetic device 7. Alternatively, the air may flow over the magnetic device 7 before passing through the condenser 3. In this case, the magnetic device 7 faces the second chamber air inlet 201 to enable the airflow to dissipate heat from the magnetic device 7 before entering the second chamber air inlet 201.

Since the magnetic device 7 has a higher temperature resistance than the condenser 3, the magnetic device 7 may face the second chamber air outlet 202.

In addition to the above heat dissipation mode, the magnetic device 7 may be cooled in other heat dissipation mode, which is not limited to the above heat dissipation mode.

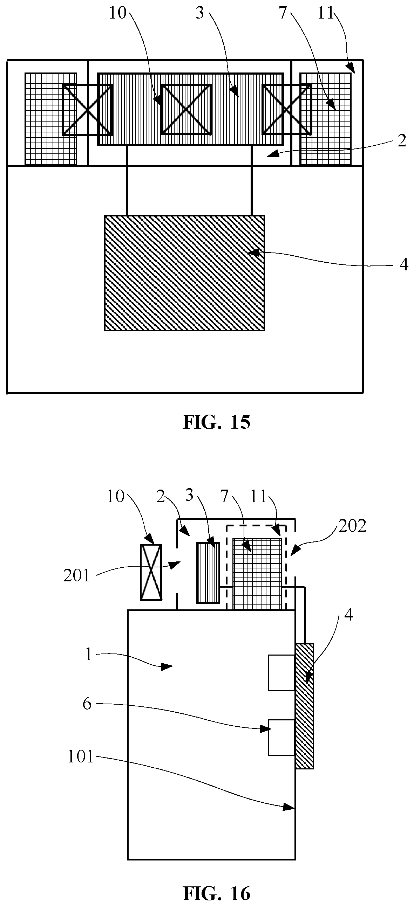

In the above embodiments, in an aspect of the present application, as shown in FIGS. 9 to 13, the magnetic device 7 may be disposed outside both the first chamber 1 and the second chamber 2. In another aspect of the present application, as shown in FIG. 14, both the magnetic device 7 and the evaporator 4 may be disposed in the fourth chamber 8, which allows air to flow over the magnetic device 7 for cooling the magnetic device 7. Additionally, as shown in FIGS. 15 to 17, the power conversion apparatus may further include a fifth chamber 11, and the magnetic device 7 is disposed in the fifth chamber 11. The fifth chamber 11 allows air to flow over the magnetic device 7 for cooling the magnetic device 7, and the evaporator 4 is disposed outside the fifth chamber 11.

The fourth chamber 8 has an air inlet and an air outlet, which may be may be called as a fourth chamber air inlet 801 and a fourth chamber air outlet 802, respectively. The fourth chamber 8 may be in communication with the external environment of the entire power conversion apparatus, or with other chambers inside the power conversion apparatus excluding the first chamber 1 and the second chamber 2, so long as the cooling of the magnetic device 7 is ensured.

To enhance the cooling efficiency, the fourth chamber 8 may be configured as an open chamber, and the fourth chamber 8 is in communication with the external environment of the power conversion apparatus.

To facilitate airflow over the magnetic device 7, the power conversion apparatus further includes a second fan 9, which is configured to drive air to flow over the magnetic device 7.

The type, number, and placement of the second fan 9 are determined based on actual conditions, which will not be limited in this embodiment.

It should be noted that the second fan 9 may be omitted if the heat dissipation requirements of the condenser are met.

The flow of air in the fourth chamber 8 may be associated with the flow of air in the second chamber 2. For example, the fourth chamber 8 is in communication with the second chamber 2. Alternatively, the fourth chamber 8 and the second chamber 2 share a common fan. Of course, the flow of air in the fourth chamber 88 may be independent from the flow of air in the second chamber 2, which will be determined based on actual conditions.

The relative positional relationship among the fourth chamber 8, the second chamber 2 and the first chamber 1 is determined based on actual conditions, which will not be limited in this embodiment.

Correspondingly, the fifth chamber 11 has an air inlet and an air outlet, which may be called as a fifth chamber air inlet 1101 and a fifth chamber air outlet 1102, respectively. To facilitate airflow over the magnetic device 7, the power conversion apparatus further includes a third fan 10, which is configured to drive air to flow over the magnetic device 7. The type, number, and placement of the third fan 10 are determined based on actual conditions, which will not be limited in this embodiment. It should be noted that the third fan 10 may be omitted if the heat dissipation requirements of the condenser are met.

For other structures of the fifth chamber 11, reference may be made to the above description of the fourth chamber 8, which will not be described in detail herein.

In the above power conversion apparatus, there are other arrangements for the magnetic device 7. In some other embodiments, the power conversion apparatus further includes a third chamber, and there are at least two magnetic devices 7. At least one of the magnetic devices 7 is defined as a first magnetic device, and at least another one of the magnetic devices 7 is defined as a second magnetic device. The first magnetic device is disposed in the second chamber 2, whereas the second magnetic device and the evaporator 4 are both disposed in the third chamber. Alternatively, the evaporator 4 is disposed inside the third chamber or outside the third chamber.

The arrangement of the evaporator 4 and the arrangement of the magnetic device 7 have been described separately above. In practical scenarios, the arrangement of the evaporator 4 and the arrangement of the magnetic device 7 may be combined. Specific details are provided below based on six embodiments.

### First Embodiment

As shown in FIGS. 1 to 8, in the power conversion apparatus provided according to a first embodiment, the evaporator 4 is disposed outside both the first chamber 1 and the second chamber 2, and the evaporator 4 is exposed. The magnetic device 7 is disposed inside the second chamber 2.

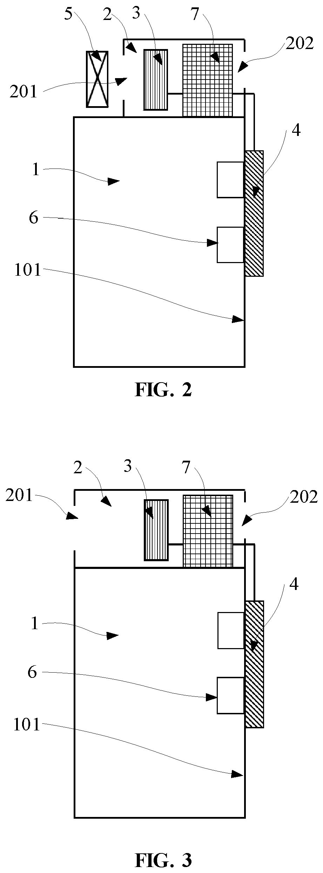

In the first embodiment, as shown in FIGS. 1 and 2, a first fan 5 is arranged and is configured to drive airflow to flow through the condenser 3. Specifically, the first fan 5 is configured to drive the airflow to flow from the second chamber air inlet 201 to the second chamber air outlet 202. The first fan 5 is arranged at the second chamber air inlet 201. Alternatively, the first fan 5 may be arranged at the second chamber air outlet 202.

As shown in FIG. 1, the first fan 5 is disposed inside the second chamber 2. As shown in FIG. 2, the first fan 5 is disposed outside the second chamber 2.

In the structures shown in FIGS. 1 and 2, since the magnetic device 7 is disposed in the second chamber 2, forced air cooling is achieved for both the condenser 3 and the magnetic device 7, thereby improving the heat dissipation effect. Additionally, the condenser 3 and the magnetic device 7 share the first fan 5, thereby simplifying the structure and reducing the cost.

As shown in FIG. 3, it is also possible to allow air to flow through the condenser 3 naturally, meaning that the first fan 5 is removed.

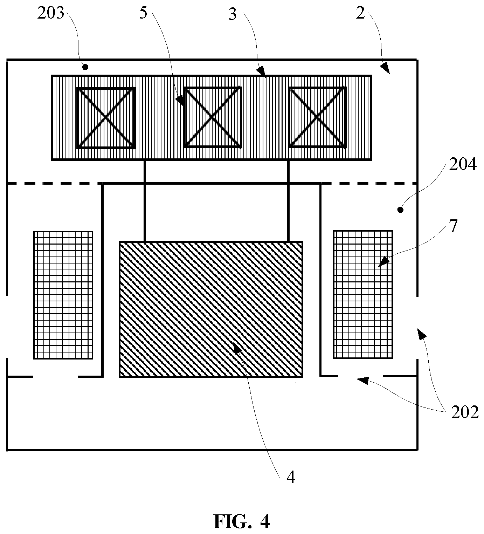

In the first embodiment, the position of the magnetic device 7 is determined based on actual situations. As shown in FIGS. 1 to 3, the magnetic device 7 may be disposed at an outer top of the first chamber 1. In this case, the second chamber 2 may be located at the top of the first chamber 1. As shown in FIGS. 4 to 8, the magnetic device 7 may be disposed on a side of the first chamber 1. In this case, the second chamber 2 may be located at the top or the side of the first chamber 1.

It should be noted that the side of the first chamber 1 refers to any side other than the top and the bottom of the first chamber 1.

In the case where the magnetic device 7 is disposed on the side of the first chamber 1, for ease of mounting, the magnetic device 7 and the evaporator 4 may be located on the same side of the first chamber 1. This arrangement facilitates the mounting and reduces the overall footprint of the structure. Additionally, for ease of mounting, both a side chamber 204 and the evaporator 4 may be arranged on the outer wall of the first chamber 1.

In the case where the magnetic device 7 and the evaporator 4 are located on the same side of the first chamber 1, the magnetic device 7 is arranged on at least one side of the evaporator 4.

In an aspect of the present application, there may be at least one magnetic device 7, which is arranged on a side of the evaporator 4.

In another aspect of the present application, there may be at least two magnetic devices 7, which are respectively distributed on both sides of the evaporator 4. Furthermore, all magnetic devices 7 are respectively distributed on both sides of the evaporator. Exemplarily, all magnetic devices 7 are respectively distributed on opposite sides of the evaporator 4. Of course, in the case that there are at least two magnetic devices 7, the magnetic devices 7 may alternatively be distributed at other positions on the evaporator 4.

In a case that the magnetic device 7 and the evaporator 4 are located on the same side of the first chamber 1, both the magnetic device 7 and the evaporator 4 may be located on a rear side of the first chamber 1. In this case, the magnetic device 7 and the evaporator 4 may be arranged on a back plate 101 of the first chamber 1.

In some embodiments, as shown in FIGS. 4 to 8, the second chamber 2 includes a top chamber 203 and at least one side chamber 204 that is in communication with the top chamber 203. The top chamber 203 is located at a top of the first chamber 1, and the side chamber 204 is located at a side of the first chamber 1. The condenser 3 is disposed in the top chamber 203, and the magnetic device 7 is disposed in the side chamber 204. At least one magnetic device 7 is housed in each side chamber 204.

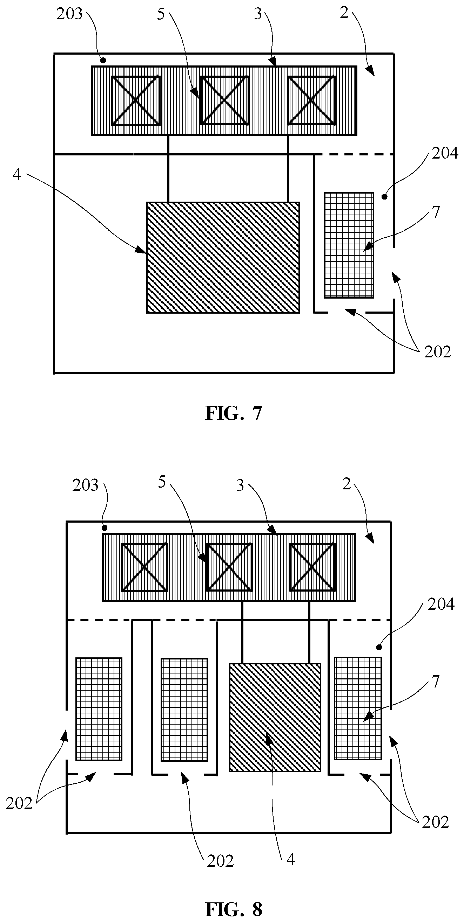

As shown in FIG. 7, there is one magnetic device 7 and one side chamber 204. As shown in FIGS. 4 to 6 and FIG. 8, there are at least two magnetic devices 7 and at least two side chambers 204, and each pair of side chambers 204 are arranged in parallel. It should be noted that each side chamber 204 is connected in series with the top chamber 203. This configuration enables the parallel flow of airflow in within each pair of side chambers 204, effectively enhancing the heat dissipation effect of the magnetic device 7 in each side chamber 204, and improving the uniformity of heat dissipation across all magnetic devices 7.

It should be noted that within the second chamber 2, the condenser 3 may be located upstream or downstream of the magnetic device 7 along the flow direction of airflow depending on the actual situation, which is not limited in this embodiment. Due to the relatively high temperature resistance of the magnetic device 7, the condenser 3 may be located upstream of the magnetic device 7 along the flow direction of airflow within the second chamber 2.

As shown in FIG. 4, two side chambers 204 and the evaporator 4 are located on the same side of the first chamber 1, and the two side chambers 204 are respectively located on both sides of the evaporator 4. In a case that the two side chambers 204 are connected in parallel, an air duct within the second chamber 2 is in a "π" shape. As shown in FIG. 8, three side chambers 204 and the evaporator 4 are located on the same side of the first chamber 1, and the three side chambers 204 are distributed on both sides of the evaporator 4. As shown in FIG. 7, a single side chamber 204 and the evaporator 4 are located on the same side of the first chamber 1, and the single side chamber 204 is located on one side of the evaporator 4.

In the first embodiment, each side chamber 204 has at least one second chamber air outlet 202, and each top chamber has at least one second chamber air inlet 201. Of course, it is possible to interchange the positions of the second chamber air outlet 202 and the second chamber air inlet 201, which will not be limited in the first embodiment.

In the first embodiment, to prevent the airflow discharged out of the second chamber 2 from affecting the evaporator 4, the second chamber air outlet 202 may not face the evaporator 4 so that the airflow discharged from the second chamber air outlet 202 bypasses the evaporator 4. For example, taking the scenario where the second chamber air outlet 202 is provided on the side chamber 204, and both the side chamber 204 and the evaporator 4 are provided on a side of the first chamber 1, the second chamber air outlet 202 is located at a bottom of the side chamber 204 or on a side of the side chamber 204 away from the evaporator 4.

In the first embodiment, the magnetic device 7 within the second chamber 2 may be defined as a first magnetic device. The power conversion apparatus further includes a third chamber, within which a second magnetic device is arranged. There is at least one first magnetic device and at least one second magnetic device. In this case, the evaporator 4 may be disposed either inside or outside the third chamber.

To facilitate the cooling of the second magnetic device, the third chamber may be configured to allow air to flow through the second magnetic device to cool the second magnetic device. The power conversion apparatus may further include a fan that is configured to drive air to flow through the third chamber. Regarding the structure of the third chamber and the fan corresponding to the third chamber, reference may be made to the fourth chamber 8 and the second fan 9, as well as the fifth chamber 11 and the third fan 10 described above, which will not be described in detail herein.

In the first embodiment, for other structures of the power conversion apparatus, reference may be made to the preceding descriptions, which will not be described in detail herein.

### Second Embodiment

As shown in FIGS. 9 and 10, a difference between the power conversion apparatus provided in a second embodiment and that in the first embodiment primarily lies in the fact that the magnetic device 7 is arranged outside both the first chamber 1 and the second chamber 2.

In the second embodiment, the evaporator 4 is arranged outside both the first chamber 1 and the second chamber 2. Moreover, the evaporator 4 and the magnetic device 7 are arranged independently, meaning that the heat dissipation of the magnetic device 7 is unrelated to the evaporator 4.

In the second embodiment, the second chamber 2 may be located on the top of the first chamber 1. In this case, the magnetic device 7 may be disposed at the top, side or other positions of the first chamber 1.

In the second embodiment, to prevent the airflow discharged out of the second chamber 2 from affecting the evaporator 4, the second chamber air outlet 202 may not face the evaporator 4 so that the airflow discharged from the second chamber air outlet 202 does not flow through the evaporator 4. For example, assuming the second chamber 2 may be arranged at the top of the first chamber 1 and the evaporator 4 is arranged on the side of the first chamber 1, the second chamber air outlet 202 is located on a side of the second chamber 2, and an axis of the second chamber air outlet 202 may be parallel to the horizontal direction.

In the second embodiment, there are two dissipate heat modes for the magnetic device 7. In one aspect of the present application, as shown in FIG. 9, the magnetic device 7 may employ natural heat dissipation for cooling. In this case, the magnetic device 7 may be arranged on an outer wall of the first chamber 1. When the evaporator 4 is also arranged on the outer wall of the first chamber 1, the magnetic device 7 and the evaporator 4 are located on the same side of the first chamber 1, and are distributed from bottom to top. Exemplarily, both the magnetic device 7 and the evaporator 4 are arranged on the back plate 101 of the first chamber 1.

In another aspect of the present application, as shown in FIG. 10, under the action of the first fan 5, the air flowing through the condenser 3 is directed towards the magnetic device 7. Specifically, the magnetic device 7 faces the second chamber air outlet 202, allowing the airflow discharged from the second chamber air outlet 202 to dissipate heat from the magnetic device 7. Alternatively, the magnetic device 7 may face the second chamber air inlet 201 (as detailed above), and the heat dissipation mode is not limited to that shown in FIG. 10.

In the second embodiment, the first fan 5 may or may not be provided, depending on actual conditions, which will not be limited in the second embodiment.

In the second embodiment, for other structures of the power conversion apparatus, reference may be made to the preceding descriptions, which will not be described in detail herein.

### Third Embodiment

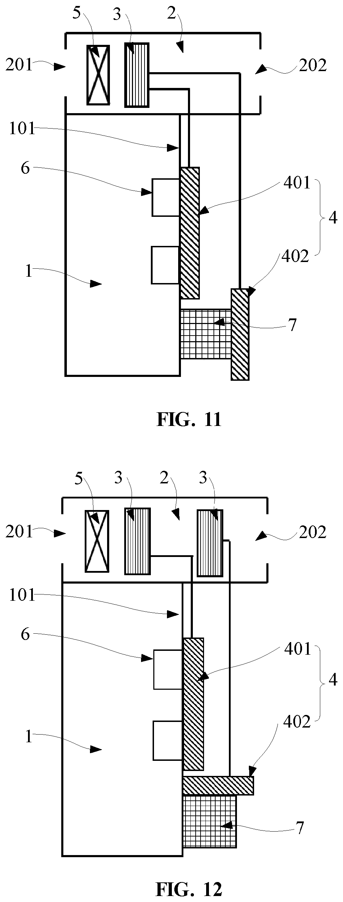

As shown in FIGS. 11 to 13, a difference between the power conversion apparatus provided in the present embodiment and that in the second embodiment primarily lies in the fact that the heat dissipation of the magnetic device 7 is associated with the evaporator 4. Specifically, the evaporator 4 is further configured to absorb heat from the magnetic device 7.

In the present embodiment, the evaporator 4 is in direct contact with the magnetic device 7, or the evaporator 4 is in indirect contact with the magnetic device 7 via a thermal conductive member.

The evaporator 4 includes a first evaporation module 401 and a second evaporation module 402. The first evaporation module 401 is configured to absorb heat from the power device 6, and the second evaporation module 402 is configured to absorb heat from the magnetic device 7.

In one aspect of the present application, as shown in FIGS. 11 and 12, the first evaporation module 401 and the second evaporation module 402 are different. In this case, as shown in FIG. 11, the first evaporation module 401 and the second evaporation module 402 may share the same condenser 3. As shown in FIG. 12, the first evaporation module 401 and the second evaporation module 402 may be connected to distinct condensers 3 respectively.

The first evaporation module 401 and the second evaporation module 402 may be arranged in parallel with each other or perpendicular to each other, or in any other configuration, which is not limited in this embodiment.

In another aspect of the present application, as shown in FIG. 13, the first evaporation module 401 and the second evaporation module 402 are the same evaporation module. In this case, the magnetic device 7 and the power device 6 may be respectively distributed on opposite sides of the evaporation module 403.

In the third embodiment, the magnetic device 7 and the evaporator 4 are disposed outside both the first chamber 1 and the second chamber 2. Alternatively, the magnetic device 7 and the evaporator 4 may be both disposed in the fourth chamber 8, the magnetic device 7 is disposed outside both the first chamber 1 and the second chamber 2, whereas the evaporator 4 is disposed in the first chamber 1. Alternatively, the magnetic device 7 is disposed outside both the first chamber 1 and the second chamber 2, whereas the evaporator 4 is disposed in the fourth chamber 8. Alternatively, the magnetic device 7 is disposed in the fourth chamber 8 while the evaporator 4 is disposed in the first chamber 1. Alternatively, the magnetic device 7 and the evaporator 4 are arranged in other configurations.

### Fourth Embodiment

As shown in FIG. 14, a difference between the power conversion apparatus provided in the fourth embodiment and that in the first embodiment primarily lies in the fact that both the evaporator 4 and the magnetic device 7 are disposed in the fourth chamber 8.

In the fourth embodiment, for convenience of mounting, the evaporator 4 may be disposed at the top or side of the first chamber 1. Correspondingly, the magnetic device 7 may be disposed at the top or side of the first chamber 1. Furthermore, the evaporator 4 and the magnetic device 7 are located on the same side of the first chamber 1. Based on this configuration, the fourth chamber 8 may be disposed on the side of the first chamber 1. In this case, the second chamber 2 is distributed at the top of both the first chamber 1 and the fourth chamber 8.

For ease of mounting, the fourth chamber 8 may be arranged at the rear of the first chamber 1, specifically disposed on the back plate 101 of the first chamber 1.

To minimize the influence of the airflow within the fourth chamber 8 on the evaporator 4, the fourth chamber 8 may be provided with an air duct for air flow, and the air duct is configured for air to flow over the magnetic device 7 but bypassing the evaporator 4.

As described above, the fourth chamber 8 has a fourth chamber air inlet 801 and a fourth chamber air outlet 802. In order to reduce the influence of airflow within the fourth chamber 8 on the evaporator 4, it is also possible that one of the fourth chamber air inlet 801 and the fourth chamber air outlet 802 is provided lower than the magnetic device 7, whereas the other is provided higher than the magnetic device 7. Additionally, the magnetic device 7 is located lower than the evaporator 4, and the one of the fourth chamber air inlet 801 and the fourth chamber air outlet 802 that is located higher than the magnetic device 7 should be arranged lower than a top end of the evaporator 4.

Exemplarily, the fourth chamber air inlet 801, the magnetic device 7 and the evaporator 4 are distributed from bottom to top. The fourth chamber air outlet 802 may be disposed on a side of the fourth chamber 8 away from the evaporator 4, and the fourth chamber air outlet 802 is provided higher than the magnetic device 7 and lower than the top end of the evaporator 4.

In practical scenarios, the fourth chamber air inlet 801, the fourth chamber air outlet 802, the magnetic device 7 and the evaporator 4 may be distributed in other configurations, which will not be limited to the structure shown in FIG. 14.

The second fan 9 may or may not be arranged in the fourth chamber 8, depending on the heat dissipation requirements of the magnetic device 7, which will not be limited in the fourth embodiment.

To facilitate the mounting of the second fan 9, the second fan 9 may be disposed on a side of the magnetic device 7 away from the evaporator 4. Specifically, the second fan 9 may be disposed either inside or outside the fourth chamber 8.

In the fourth embodiment, for other structures of the power conversion apparatus, reference may be made to the preceding descriptions, which will not be described in detail herein.

### Fifth Embodiment

As shown in FIGS. 15 to 17, a difference between the power conversion apparatus provided in the fifth embodiment and that in the first embodiment primarily lies in the fact that a fifth chamber 11 is provided, the magnetic device 7 is disposed inside the fifth chamber 11, whereas the evaporator 4 is disposed outside both the fifth chamber 11 and the first chamber 1.

In the fifth embodiment, both the second chamber 2 and the fifth chamber 11 may be disposed at the top of the first chamber 1. Alternatively, the second chamber 2 may be disposed at the top of the first chamber 1, whereas the fifth chamber 11 may be disposed on the side of the first chamber 1. Alternatively, the second chamber 2 and the fifth chamber 11 may be distributed at other locations, which will not be limited in this embodiment.

As described above, the fifth chamber 11 has a fifth chamber air inlet 1101 and a fifth chamber air outlet 1102, allowing air to flow through the magnetic device 7 for cooling the magnetic device 7. The positions of the fifth chamber air inlet 1101 and the fifth chamber air outlet 1102 are determined based on actual conditions.

In the fifth embodiment, a third fan 10 may or may not be provided, depending on the heat dissipation requirements of the magnetic device 7.

In a case that a third fan 10 is provided, it may be disposed either inside or outside the fifth chamber 11. Specifically, the third fan 10 is disposed at the fifth chamber air inlet 1101 or the fifth chamber air outlet 1102.

Since both the second chamber 2 and the fifth chamber 11 require airflow to pass through, the fifth chamber 11 and the second chamber 2 may share a fan, enabling air to flow through the condenser 3 and the magnetic device 7, meaning that the condenser 3 and the magnetic device 7 share the same fan. In this case, the first fan 5 and the third fan 10 mentioned above are actually the same fan.

The fifth chamber 11 and the second chamber 2 may share one or more fans, depending on actual conditions.

In the fifth embodiment, the fifth chamber 11 and the second chamber 2 share a fan, so that the number of fans may be reduced, thereby simplifying the structure of the power conversion apparatus and lowering the cost of the power conversion apparatus.

In the case where the fifth chamber 11 and the second chamber 2 share a fan, they may be arranged in parallel or in series.

In the case where the fifth chamber 11 and the second chamber 2 are arranged in parallel, the fan is disposed outside both the second chamber 2 and the fifth chamber 11. Optionally, the fifth chamber air inlet 1101 and the second chamber air inlet 201 may be provided on the same side. Exemplarily, the fan is arranged at both the fifth chamber air inlet 1101 and the second chamber air inlet 201, so that the air flowing through the fan is divided into two portions: one portion flows through the second chamber 2, whereas the other portion flows through the fifth chamber 11.

In order to facilitate the positioning of the fifth chamber air inlet 1101 and the second chamber air inlet 201 on the same side, both the second chamber 2 and the fifth chamber 11 are arranged at the top of the first chamber 1, meaning that the fifth chamber 11 and the second chamber 2 are arranged in parallel. Alternatively, the fifth chamber 11 may be located elsewhere, which is not limited in the fifth embodiment.

In the case where the fifth chamber 11 and the second chamber 2 are arranged in series, the fifth chamber 11 is located downstream or upstream of the second chamber 2.

In the fifth embodiment, there may be one or more fifth chambers 11. In a case that there are two or more fifth chambers 11, to enhance the heat dissipation effect of the magnetic device 7, the fifth chambers 11 may be arranged in parallel with the second chamber 2, meaning that every two fifth chambers 11 are also arranged in parallel.

In the case where there are two or more fifth chambers 11, the fifth chambers 11 may be arranged in series with the second chambers 2, meaning that every two fifth chambers 11 are also arranged in series.

In the case where there are two or more fifth chambers 11, at least one of the fifth chambers 11 may be arranged in parallel with the second chamber 2, whereas at least another one of the fifth chambers 11 may be arranged in series with the second chamber 2.

In the case where there are two or more fifth chambers 11 and they are arranged in parallel with the second chamber 2, all the fifth chambers 11 may be respectively distributed on at least two sides of the second chamber 2 to facilitate the parallel arrangement of the fifth chamber 11 and the second chamber 2. Alternatively, all the fifth chambers 11 may be distributed on one side of the second chamber 2.

In the case where there are two or more fifth chambers 11 and they are arranged in series with the second chamber 2, all the fifth chambers 11 may be distributed on one side of the second chamber 2 to facilitate the series arrangement of the fifth chamber 11 and the second chamber 2. Alternatively, all the fifth chambers 11 may be distributed on at least two sides of the second chamber 2.

In the fifth embodiment, for other structures of the power conversion apparatus, reference may be made to the preceding descriptions, which will not be described in detail herein.

### Sixth Embodiment

As shown in FIGS. 18 and 19, a difference between the power conversion apparatus provided in the present embodiment and that in the first embodiment primarily lies in the fact that the evaporator 4 is disposed in the first chamber 1.

As shown in FIG. 18, there is a gap between the evaporator 4 and an inner wall of the first chamber 1. Alternatively, as shown in FIG. 19, the evaporator 4 is in contact with the inner wall of the first chamber 1.

In the case where there is a gap between the evaporator 4 and the inner wall of the first chamber 1, an electronic device may or may not be arranged in the gap, which will not be limited in this embodiment.

In the sixth embodiment, the magnetic device 7 is disposed inside the second chamber 2. Alternatively, the magnetic device 7 may be disposed outside both the first chamber 1 and the second chamber 2, or the magnetic device 7 may be disposed in a chamber other than the second chamber 2.

In this sixth embodiment, for other structures of the power conversion apparatus, reference may be made to the preceding descriptions, which will not be described in detail herein.

In the power conversion apparatus provided according to the embodiments of the present application, the combinations of the arrangement of the evaporator 4 and the arrangement of the magnetic device 7 are not limited to the six embodiments described above. Other combinations may be selected depending on actual conditions, which will not be limited in the embodiments of the present application.

The power conversion apparatus provided in the embodiments of the present application may be an inverter, a power conversion system or other types, which will not be limited in the embodiments of the present application.

The above description of the disclosed embodiments enables those skilled in the art to implement or utilize the present application. It is apparent for those skilled in the art to make various modifications to these embodiments. The general principle defined herein may be applied to other embodiments without departing from the spirit or scope of the present application. Hence, the present application is not limited to the embodiments described herein but conforms to a widest scope in accordance with the principle and novel features disclosed herein.

## Claims

1. A power conversion apparatus, comprising: a first chamber, a second chamber, and a heat sink;
wherein, a power device is disposed in the first chamber; the heat sink comprises an evaporator and a condenser connected to the evaporator to form a circulation flow path, and the evaporator is configured to absorb heat from the power device; and
the condenser is disposed in the second chamber, which is configured to allow air to flow through the condenser for cooling the condenser, and the evaporator is disposed outside the second chamber.

2. The power conversion apparatus according to claim 1, wherein the evaporator is disposed outside the first chamber.

3. The power conversion apparatus according to claim 2, a magnetic device is further disposed in the second chamber.

4. The power conversion apparatus according to claim 2, wherein the magnetic device is disposed on an outer top of the first chamber.

5. The power conversion apparatus according to claim 2, wherein the magnetic device is disposed on a side of the first chamber.

6. The power conversion apparatus according to claim 5, wherein the magnetic device and the evaporator are located on a same side of the first chamber.

7. The power conversion apparatus according to claim 6, wherein there is at least one magnetic device, which is distributed on one side of the evaporator; or
there are at least two magnetic devices, which are respectively distributed on both sides of the evaporator.

8. The power conversion apparatus according to claim 2, wherein
the magnetic device located in the second chamber is defined as a first magnetic device; and
wherein the power conversion apparatus further comprises a third chamber, within which a second magnetic device is arranged.

9. The power conversion apparatus according to claim 8, wherein
the evaporator is located in the third chamber;
and/or, the third chamber is configured to allow air to flow over the second magnetic device for cooling the second magnetic device.

10. The power conversion apparatus according to claim 2, wherein a magnetic device is further disposed outside both the second chamber and the first chamber.

11. The power conversion apparatus according to claim 10, wherein the evaporator and the magnetic device are arranged independently.

12. The power conversion apparatus according to claim 10, wherein the evaporator comprises a first evaporation module and a second evaporation module, the first evaporation module is configured to absorb heat from the power device, and the second evaporation module is configured to absorb heat from the magnetic device.

13. The power conversion apparatus according to claim 12, wherein the first evaporation module and the second evaporation module are different;
the first evaporation module and the second evaporation module share a same condenser; or the first evaporation module and the second evaporation module are respectively connected to different condensers.

14. The power conversion apparatus according to claim 12, wherein the first evaporation module and the second evaporation module are the same evaporation module.

15. The power conversion apparatus according to claim 10, further comprising a fourth chamber, wherein the evaporator is disposed in the fourth chamber.

16. The power conversion apparatus according to claim 9 or 15, wherein the evaporator is disposed on a top or a side of the first chamber.

17. The power conversion apparatus according to claim 15, wherein the magnetic device is disposed in the fourth chamber.

18. The power conversion apparatus according to claim 17, wherein the fourth chamber is configured to allow air to flow through the magnetic device for cooling the magnetic device.

19. The power conversion apparatus according to claim 18, wherein
the fourth chamber is provided with an air duct for air flow, and the air duct is configured for air to flow over the magnetic device but bypasses the evaporator;
and/or, one of a fourth chamber air inlet and a fourth chamber air outlet is provided lower than the magnetic device, whereas the other one is provided higher than the magnetic device, wherein the magnetic device is located lower than the evaporator, and the other one of the fourth chamber air inlet and the fourth chamber air outlet, being provided higher than the magnetic device, is lower than a top end of the evaporator;
and/or, a fan is disposed in the fourth chamber and located on a side of the magnetic device away from the evaporator.

20. The power conversion apparatus according to claim 10, further comprising a fifth chamber, within which the magnetic device is located, and the fifth chamber is configured to allow air to flow over the magnetic device for cooling the magnetic device.

21. The power conversion apparatus according to claim 20, wherein the second chamber and the fifth chamber share a fan to enable air to flow through the condenser and over the magnetic device, wherein the fan is located outside both the second chamber and the fifth chamber.

22. The power conversion apparatus according to claim 20, wherein the fifth chamber is arranged in parallel or in series with the second chamber.

23. The power conversion apparatus according to claim 10, wherein a second chamber air inlet faces the magnetic device to allow the airflow to dissipate heat from the magnetic device before entering the second chamber air inlet; or
a second chamber air outlet faces the magnetic device to allow the airflow discharged from the second chamber air outlet to dissipate heat from the magnetic device.

24. The power conversion apparatus according to claim 1, wherein the evaporator is disposed in the first chamber.
